# EUROPEAN PATENT APPLICATION

(11) **EP 1 441 387 A2**
(43) Date of publication of application: **28.07.2004**
(21) Application number: 04000998.7
(22) Date of filing: 19.01.2004
(51) Int. Cl.: H01L 21/306, H01L 21/00, H01L 21/20, H01L 21/762

(54) **Etching method**

(30) Priority: 20.01.2003 JP 2003011275
(71) Applicant: CANON KABUSHIKI KAISHA, Tokyo (JP)
(72) Inventor: Takanashi, Kazuhito, Tokyo (JP); Yamagata, Kenji, Tokyo (JP); Sakaguchi, Kiyofumi, Tokyo (JP); Yanagita, Kazutaka, Tokyo (JP); Sugai, Takashi, Tokyo (JP); Tsuboi, Takashi, Tokyo (JP)
(74) Representative: Leson, Thomas Johannes Alois, Dipl.-Ing.

(57) **Abstract**

An object of this invention is to suppress the amount of etchant used. A liquid etchant (3) is stored in an etchant vessel (4), and vaporized by a vaporization unit (6). A fragile layer (1a) such as a porous layer is selectively etched with the vaporized etchant.

## Description

### FIELD OF THE INVENTION

The present invention relates to an etching technique suitable for removing a fragile layer such as a porous layer or ion-implanted layer in a member.

### BACKGROUND OF THE INVENTION

As one of SOI (Silicon On Insulator or Semiconductor On Insulator) substrate manufacturing methods, a seed substrate having an epitaxial single-crystal silicon layer on a porous silicon layer and a handle layer are bonded into a bonded substrate stack. The bonded substrate stack is divided at the porous Si layer portion to transfer the epitaxial single-crystal Si layer from the seed substrate to the handle substrate.

The porous Si layer remaining on the handle substrate surface (epitaxial single-crystal Si layer) after transferring the epitaxial single-crystal Si layer can be removed by selective etching, as disclosed in, e.g., Japanese Patent Laid-Open No. 6-342784.

A porous Si layer can be uniformly etched by alcohol addition disclosed in Japanese Patent Laid-Open No. 6-342784, ultrasonic processing disclosed in Japanese Patent Laid-Open No. 11-204494, etching solution replacement disclosed in Japanese Patent Laid-Open No. 11-204495, reduced-pressure processing disclosed in Japanese Patent Laid-Open Nos. 2000-133558 and 2000-133632, or deaeration disclosed in Japanese Patent Laid-Open Nos. 2000-150495 and 2000-155837.

Any technique etches a porous Si layer by dipping in a solution a substrate on which the porous Si layer is exposed.

The conventional techniques perform etching by dipping an etching target in a solution, and uses a large amount of etching chemical (etching solution). This problem becomes more serious along with a recent increase in substrate size.

If the substrate size becomes large, it becomes more difficult to uniformly etch a porous Si layer. To uniformly etch the entire surface of the porous Si layer, the penetration speed of the chemical into the porous Si layer must be increased. Alternatively, replacement of the chemical in the pores of the porous Si layer (replacement of a chemical which has already contributed to reaction with a new chemical) must be done more efficiently.

In the conventional techniques, an etching target is directly dipped in a chemical, and may be directly influenced by contamination of the chemical itself, e.g., contamination by a trace metal.

### SUMMARY OF THE INVENTION

The present invention has been made in consideration of the above situation, and has as its object to mainly reduce the amount of etchant used. Note that preferred embodiments of the present invention also consider uniform etching of a fragile layer such as a porous layer and reduction of contamination of an etching target by an etchant.

According to the present invention, an etching method of etching a fragile layer of a member having the fragile layer is characterized by comprising vaporizing a liquid etchant to etch the fragile layer of the member with the vaporized etchant. The fragile layer can include, e.g., a porous layer or an ion-implanted layer.

According to a preferred aspect of the present invention, the fragile layer includes silicon having a fragile structure. In this case, the etchant preferably contains hydrogen fluoride and hydrogen peroxide.

According to another preferred aspect of the present invention, the liquid etchant is preferably vaporized by heating. The liquid etchant is preferably vaporized by heating the liquid etchant to a temperature within a range of 40 to 50°C.

According to the second aspect of the present invention, an etching apparatus for etching a member comprises a reaction vessel which stores the member, and a vaporization unit which vaporizes a liquid etchant by heating. In this apparatus, the member stored in the reaction vessel is etched with the vaporized etchant.

According to still another preferred aspect of the present invention, the vaporization unit can be so configured as to vaporize the liquid etchant inside the reaction vessel.

According to still another preferred aspect of the present invention, the vaporization unit is so configured as to vaporize the liquid etchant outside the reaction vessel. In this case, the etching apparatus further comprises a supply portion which supplies the etchant vaporized by the vaporization unit into the reaction vessel. The supply portion can include an etchant vessel which stores the liquid etchant, a first supply path which supplies a predetermined gas to the etchant vessel, and a second supply path which communicates the etchant vessel with the reaction vessel. The supply portion can be so configured as to supply the predetermined gas into the etchant vessel via the first supply path and supply the etchant vaporized in the etchant vessel into the reaction vessel via the second supply path.

According to still another preferred aspect of the present invention, the vaporization unit is preferably so configured as to be able to heat the liquid etchant to a temperature within a range of 40 to 50° C.

According to the third aspect of the present invention, an etching apparatus for etching a member comprises a reaction vessel which stores the member, and a vaporization unit which vaporizes a liquid etchant inside the reaction vessel, wherein the member stored in the reaction vessel is etched with the vaporized etchant. The vaporization unit is preferably so configured as to vaporize the liquid etchant by heating.

According to the fourth aspect of the present invention, an etching apparatus for etching a member comprises a reaction vessel which stores the member, an etchant vessel which is arranged outside the reaction vessel and stores a liquid etchant, a vaporization unit which vaporizes the etchant in the etchant vessel, a first supply path which supplies a predetermined gas into the etchant vessel, and a second supply path which communicates the etchant vessel with the reaction vessel, wherein the etchant vaporized in the etchant vessel is supplied into the reaction vessel via the second supply path by supplying the predetermined gas into the etchant vessel via the first supply path. The vaporization unit is preferably so configured as to vaporize the liquid etchant by heating.

The etching apparatus according to each of the third and fourth aspects can further comprise a holding unit which holds one or a plurality of members in the reaction vessel. In other words, the etching apparatus may be configured as a single-wafer apparatus or batch apparatus.

According to the fifth aspect of the present invention, a substrate manufacturing method comprises steps of preparing a first substrate having a fragile layer and a transfer layer formed on the fragile layer, bonding a surface of the transfer layer of the first substrate to a second substrate to fabricate a bonded substrate stack, dividing the bonded substrate stack at a portion of the fragile layer, and etching the fragile layer remaining on the transfer layer transferred to the second substrate, wherein the etching step includes a step of vaporizing a liquid etchant and etching the remaining fragile layer with the vaporized etchant. The fragile layer can include, e.g., a porous layer or an ion-implanted layer.

Other features and advantages of the present invention will be apparent from the following description taken in conjunction with the accompanying drawings, in which like reference characters designate the same or similar parts throughout the figures thereof.

### BRIEF DESCRIPTION OF THE DRAWINGS

The accompanying drawings, which are incorporated in and constitute a part of the specification, illustrate embodiments of the invention and, together with the description, serve to explain the principles of the invention.
Fig. 1 is a view schematically showing the arrangement of an etching apparatus according to the first preferred embodiment of the present invention;
Fig. 2 is a view schematically showing the arrangement of an etching apparatus according to the second preferred embodiment of the present invention;
Figs. 3A and 3B are schematic sectional views for explaining the first example of the present invention;
Figs. 4A to 4E are schematic sectional views for explaining the third embodiment and second example of the present invention;
Fig. 5 is a graph for explaining the third example of the present invention; and
Fig. 6 is a graph for explaining the third example of the present invention.

### DETAILED DESCRIPTION OF THE PREFERRED EMBODIMENTS

Preferred embodiments of the present invention will be illustratively described below with reference to the accompanying drawings.

### [First Embodiment]

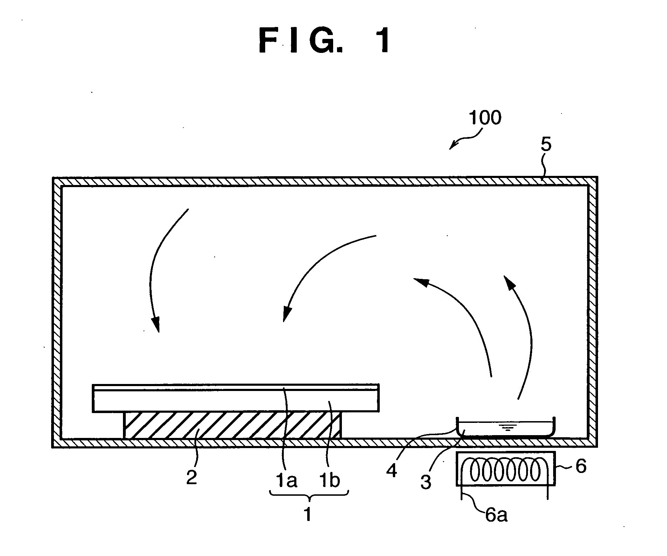

Fig. 1 is a view schematically showing the arrangement of an etching apparatus according to the first preferred embodiment of the present invention. An etching apparatus and etching method according to the first embodiment of the present invention will be described with reference to Fig. 1.

An etching apparatus 100 shown in Fig. 1 is suitable for selectively etching a fragile layer such as a porous layer or ion-implanted layer in a member. A porous layer can be formed by anodizing a member such as a silicon substrate. An ion-implanted layer can be formed by ion-implanting a diluent gas such as hydrogen gas into a member such as a silicon substrate. The ion-implanted layer is known to become a layer having many microcavities by annealing. Both the porous layer and ion-implanted layer have a fragile structure, and are useful for the manufacture of an SOI substrate including a step of transferring a thin semiconductor layer from a seed substrate to a handle substrate.

The etching apparatus 100 shown in Fig. 1 comprises a reaction vessel 5 which stores a substrate 1 serving as a member to be etched, a holding unit 2 which holds the substrate 1, an etchant vessel 4 which stores a liquid etchant (etching solution) 3, and a vaporization unit 6 which vaporizes the etchant 3 in the etchant vessel 4.

The substrate 1 has a fragile layer 1a such as a porous layer or ion-implanted layer on the surface of a substrate main body 1b. The fragile layer 1a is, e.g., a porous layer formed by anodizing a silicon substrate or a layer formed by implanting ions into a silicon substrate. The fragile layer 1a may exist on the entire surface of the substrate 1, or partially exist on the surface. The fragile layer 1a such as a porous layer or an ion-implanted layer after annealing has many cavities, and is more reactive than the lower substrate main body 1b. Even when the fragile layer 1a and substrate main body 1b are formed from the same material, the fragile layer 1a can be selectively etched from the substrate main body 1b at high selectivity.

The reaction vessel 5 can be typically formed as a closed vessel. The holding unit 2 holds one substrate 1 in Fig. 1, but may hold a plurality of substrates 1. When the fragile layer 1a is formed from silicon, the liquid etchant (etching solution) 3 stored in the etchant vessel 4 is preferably a solution mixture of hydrofluoric acid (aqueous hydrogen fluoride solution) and a hydrogen peroxide solution (aqueous hydrogen peroxide solution). In this case, the vaporized etchant contains hydrogen fluoride and hydrogen peroxide. When the etchant 3 contains two or more kinds of substances, these substances may be stored in separate etchant vessels and vaporized by a common vaporization unit or separate vaporization units.

The vaporization unit 6 preferably incorporates a heater 6a which heats the etchant 3 in the etchant vessel 4 to vaporize the etchant 3. The vaporization unit 6 may be arranged inside or outside the reaction vessel 5. Alternatively, part of the vaporization unit 6 may be arranged inside the reaction vessel 5, and the remaining part may be arranged outside it.

The reaction vessel 5 (or its inner surface) and the holding unit 2 and etchant vessel 4 which are arranged inside the reaction vessel 5 (and when all or part of the vaporization unit 6 is arranged inside the reaction vessel 5, this part) are preferably formed from a material almost free from particle attachment and metal contamination, e.g., a fluorocarbon resin material or metal-free rigid PVC resin.

The fragile layer 1a of the substrate 1 is etched by the etching apparatus 100 as follows. The substrate 1 is set on the holding unit 2 in the reaction vessel 5 with the fragile layer 1a facing upward. The liquid etchant 3 in the etchant vessel 4 is vaporized by the vaporization unit 6, and the vaporized etchant is provided to the fragile layer 1a. The etchant 3 is typically vaporized by heating the liquid etchant 3 in the etchant vessel 4 to a predetermined temperature by the heater 6a of the vaporization unit 6. The etchant 3 is preferably heated to a predetermined temperature within the range of 40 to 50°C. If the etchant 3 is heated to an excessively high temperature (e.g., exceeds 50°C), a trace contaminant (e.g., metal) which may be contained in the liquid etchant 3 may spread together with the vaporized etchant 3 in the reaction vessel 5, and contaminate the substrate 1. If the etchant 3 is heated to an excessively low temperature (e.g., less than 40°C), the etchant 3 hardly vaporizes.

For example, the vaporized etchant is filled in the reaction vessel 5 several ten min after the start of vaporizing the etchant 3. After several hours, the fragile layer 1a of the substrate 1 is selectively, uniformly etched away with the vaporized etchant.

According to the apparatus and method of the first embodiment, a vaporized etchant is provided to an etching target to etch it. The amount of etchant used can be dramatically reduced, compared to an apparatus and method in which an etching target is dipped in a liquid etchant (etching solution).

According to the apparatus and method of the first embodiment, a fragile layer having many cavities such as a porous layer or ion-implanted layer is etched with a vaporized etchant. The etchant can be quickly provided into the fragile layer (more specifically, cavities) over the entire surface, and the etchant which has already contributed to reaction can be replaced with a new etchant. Hence, the apparatus and method of the first embodiment can uniformly etch a fragile layer and shorten the etching processing time.

According to the apparatus and method of the first embodiment, even if the etchant is contaminated, contamination of an etching target can be easily prevented by vaporizing the etchant while leaving the contaminant in the liquid etchant.

### [Second Embodiment]

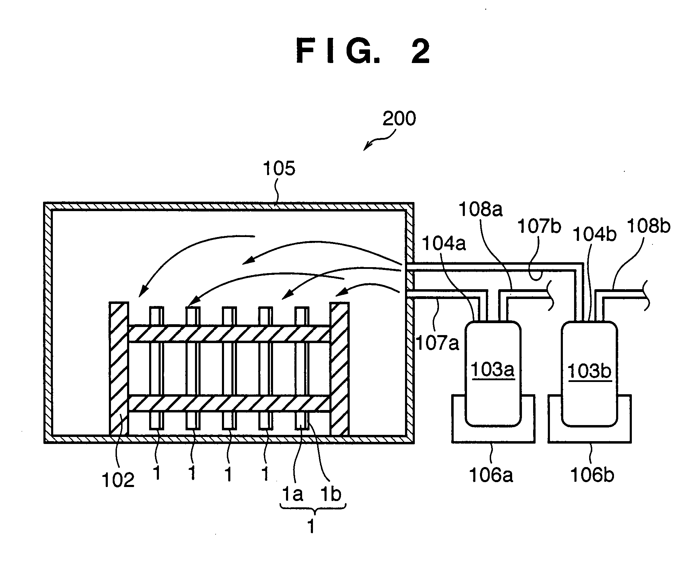

Fig. 2 is a view schematically showing the arrangement of an etching apparatus according to the second preferred embodiment of the present invention. An etching apparatus and etching method according to the second embodiment of the present invention will be described with reference to Fig. 2. The second embodiment is different from the first embodiment in that a liquid etchant is vaporized outside a reaction vessel and then supplied into the reaction vessel. The first embodiment applies to matters which will not be explicitly specified in the second embodiment.

An etching apparatus 200 shown in Fig. 2 is also suitable for selectively etching a fragile layer such as a porous layer or ion-implanted layer in a member. The etching apparatus 200 comprises a reaction vessel 105 which stores a substrate 1 serving as a member to be etched, a holding unit 102 which holds the substrate 1, etchant vessels 104a and 104b which store liquid etchants (etching solutions) 103a and 103b, vaporization units 106a and 106b which vaporize the etchants 103a and 103b in the etchant vessels 104a and 104b, supply paths 107a and 107b which supply the etchants vaporized by the vaporization units 106a and 106b to the reaction vessel 105, and supply paths 108a and 108b which supply inert gas into the etchant vessels 104a and 104b.

The substrate 1 has a fragile layer 1a such as a porous layer or ion-implanted layer on the surface of a substrate main body 1b. The reaction vessel 105 can be typically formed as a closed vessel. The holding unit 102 holds a plurality of substrates 1 in Fig. 2, but may hold one substrate 1. When the fragile layer 1a is formed from silicon, the etchants 103a and 103b stored in the etchant vessels 104a and 104b are preferably hydrofluoric acid (aqueous hydrogen fluoride solution) and a hydrogen peroxide solution (aqueous hydrogen peroxide solution). Note that two or more kinds of etchants may.be stored in a single etchant vessel and vaporized together. The vaporization units 106a and 106b preferably incorporate heaters which heat the etchants 103a and 103b in the etchant vessels 104a and 104b to vaporize the etchants 103a and 103b.

The reaction vessel 105 (or its inner surface), holding unit 102, etchant vessels 104a and 104b, and supply paths 107a, 107b, 108a, and 108b are preferably formed from a material almost free from particle attachment and metal contamination, e.g., a fluorocarbon resin material or metal-free rigid PVC resin.

The fragile layer 1a of the substrate 1 is etched by the etching apparatus 200 as follows. One or a plurality of substrates 1 are set on the holding unit 102 in the reaction vessel 105.

The liquid etchants 103a and 103b in the etchant vessels 104a and 104b are vaporized by the vaporization units 106a and 106b. The vaporized etchants are supplied into the reaction vessel 105 via the supply paths 107a and 107b by supplying inert gas into the etchant vessels 104a and 104b via the supply paths 108a and 108b. The etchants 103a and 103b are typically vaporized by heating the liquid etchants 103a and 103b in the etchant vessels 104a and 104b to a predetermined temperature by the heaters of the vaporization units 106a and 106b. The etchants 103a and 103b are preferably heated to a predetermined temperature within the range of 40 to 50°C. If the etchants 103a and 103b are heated to an excessively high temperature, a trace contaminant (e.g., metal) which may be contained in the liquid etchants 103a and 103b may spread together with the vaporized etchants 103a and 10b in the reaction vessel 105, and contaminate the substrate 1. If the etchants 103a and 103b are heated to an excessively low temperature (e.g., less than 40°C), the etchants 103a and 103b hardly vaporize.

For example, the vaporized etchants are filled in the reaction vessel 105 several ten min after the start of vaporizing the etchants 103a and 103b. After several hours, the fragile layer 1a of the substrate 1 is selectively, uniformly etched away with the vaporized etchant.

### [Third Embodiment]

The third embodiment is related to a method of manufacturing a substrate (e.g., an SOI substrate) to which the above etching method is applied.

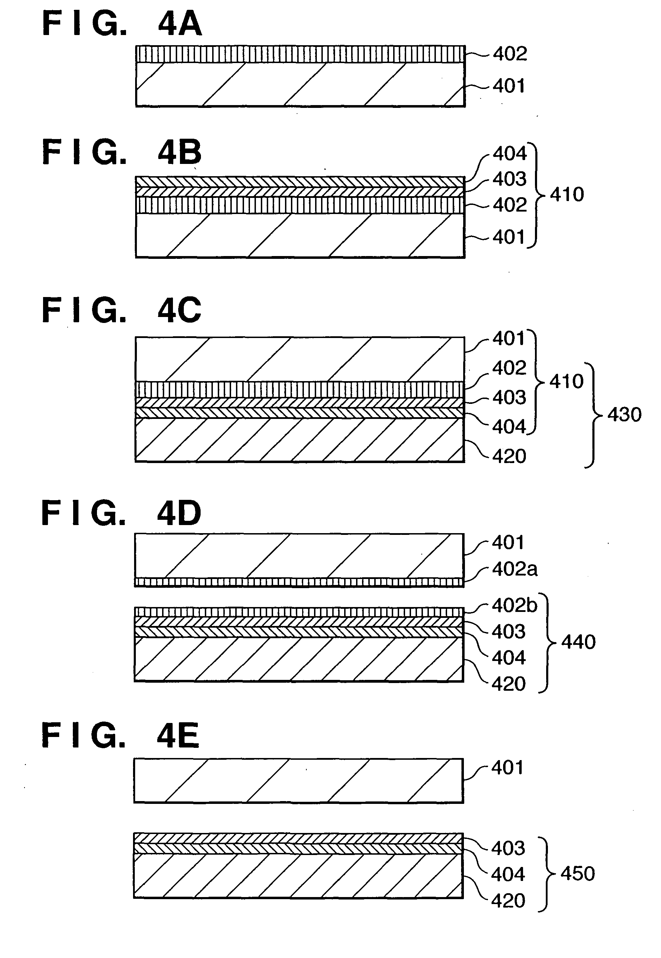

Figs. 4A to 4E are sectional views for explaining a substrate manufacturing method according to a preferred embodiment of the present invention. The substrate manufacturing method according to the preferred embodiment of the present invention will be explained with reference to Figs. 4A to 4E. In the step shown in Fig. 4A, a porous layer serving as a fragile layer 402 is formed on the surface of a first substrate (seed substrate) 401 such as a silicon substrate. The porous layer can be formed by, e.g., anodizing the surface of the substrate 401. The porous layer may have a multilayered structure of two or more layers with different porosities.

In the step shown in Fig. 4B, a semiconductor layer serving as a first transfer layer 403 is formed on the fragile layer 402. When the porous layer 402 (and substrate 401) is formed from single-crystal silicon, an epitaxial single-crystal silicon layer can be formed as the first transfer layer 403 on the porous layer 402. After that, a second transfer layer 404 is formed on the first transfer layer 403. The second transfer layer is typically an insulating layer such as a silicon oxide film. The first and second transfer layers 403 and 404 are part of the fragile layer 402, and transferred from the first substrate 401 to a second substrate 420 through the subsequent bonding step and division step.

Instead of the steps shown in Figs. 4A and 4B, a diluent gas of hydrogen or the like may be ion-implanted into a semiconductor substrate serving as the first substrate 401 to form an ion-implanted layer serving as the fragile layer 402 at a portion of the first substrate 401 at a predetermined depth. In this case, a semiconductor layer serving as the first transfer layer 403 remains on the fragile layer 402. The second transfer layer 404 can be formed on the surface of the first transfer layer 403. Even by this method, a structure as shown in Fig. 4B can be obtained.

In the step shown in Fig. 4C, the second substrate (handle substrate) 420 is bonded to a surface, on the side of the transfer layers 403 and 404, of a first substrate 410 having the transfer layers 403 and 404 as shown in Fig. 4B, thus fabricating a bonded substrate stack 430.

In the step shown in Fig. 4D, the bonded substrate stack 430 is divided into two substrates at the portion of the fragile layer (separation layer) 402. This division step can be executed by causing a fluid to act in or near the fragile layer 402, for example, blowing a fluid jet to the fragile layer 402. The method using a water jet is known as a water jet method. After division, the second transfer layer 404, first transfer layer 403, and a part 402b of the fragile layer 402 are left sequentially from the inside (lower side) on the second substrate 420. That is, the first and second transfer layers 403 and 404 on the first substrate 401 are transferred to the second substrate 420 by the above steps. When an ion-implanted layer is formed as the fragile layer 402, many small cavities may be generated in the ion-implanted layer by annealing, and the bonded substrate stack 430 may be divided into two substrates at the ion-implanted layer portion.

In the step shown in Fig. 4E, a fragile layer 402a remaining on a second substrate 440 after the division step is removed by the etching apparatus and etching method described in the first or second embodiment, thereby obtaining a substrate 450.

When the first transfer layer 403 is a semiconductor layer such as a single-crystal silicon layer and the second transfer layer 404 is an insulating layer, the substrate 450 is called an SOI (Silicon On Insulator or Semiconductor On Insulator) substrate.

As described above, according to the third embodiment, the first or second embodiment is applied to the etching step of a fragile layer remaining on the substrate surface after division. The remaining fragile layer can be uniformly, quickly etched with a small amount of etchant without any contamination.

### [Examples]

Examples of the above embodiments will be described. The following examples are merely application examples of the present invention, and do not limit the present invention unless the scope of the claims is explicitly limited on the basis of the following examples.

### [First Example]

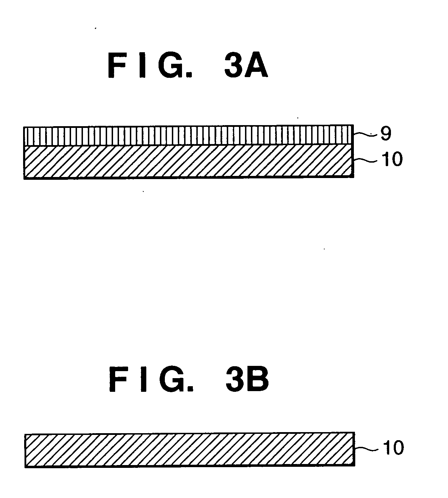

The first example is related to a method of etching a porous Si layer on the surface of an Si substrate by using an etching apparatus 100 shown in Fig. 1. The first example will be explained with reference to Figs. 3A and 3B.

A 12" single-crystal Si substrate was anodized to form porous Si on the surface. As schematically shown in Fig. 3A, a substrate having a porous Si layer 9 on an unporous Si portion 10 was obtained. Anodization conditions were as follows.
Current density: 7 (mA · cm⁻²)
Anodization solution:
HF : H₂O : C₂H₅OH = 1 : 1 : 1 (volume ratio)
Time: 2 (h)
Porous Si layer thickness: 120 (µm)

The substrate schematically shown in Fig. 3A was set on a holding unit 2 of the etching apparatus 100 shown in Fig. 1, and only the porous Si layer 9 was etched by the etching apparatus 100. By using a vaporized etchant, the etchant is quickly provided into the porous Si layer, unlike conventional etching in an etching solution. The etchant replacement efficiency (efficiency of replacing an etchant which has already contributed to etching reaction with a new etchant) increases about 1.2 to 1.5 times in comparison with etching in an etching solution. The selective etching time of a porous Si layer is about 4 to 4.5 h in the prior art, but is shortened to about 3.5 h in the example to which the present invention is applied. In the first example, it was confirmed that the entire porous Si layer was selectively, uniformly etched away and a substrate 10 as schematically shown in Fig. 3B was obtained.

### [Second Example]

The second example is related to a method of manufacturing an SOI substrate by using an etching apparatus 200 shown in Fig. 2, and further implements the third embodiment. The second example will be explained with reference to Figs. 4A to 4E.

Two anodization processes were done for an 8" single-crystal Si substrate serving as a first substrate 401, thereby forming a two-layered porous Si layer 402 on the substrate (Fig. 4A). Anodization conditions were as follows.

### <First Anodization>

Current density: 7 (mA ·cm⁻²)
Anodization solution:
HF : H₂O : C₂H₅OH = 1 : 1 : 1 (volume ratio)
Time: 5 (min)
Porous Si layer thickness: 5.5 (µm)

### <Second Anodization>

Current density: 30 (mA · cm⁻²)
Anodization solution:
HF : H₂O : C₂H₅OH = 1 : 1 : 1 (volume ratio)
Time: 110 (sec)
Porous Si layer thickness: 3.0 (µm)

The substrate was oxidized in an oxygen atmosphere at 400°C for 1 h. As a result of oxidization, the inner wall of the pore of the porous Si layer 402 was covered with a thermal oxide film.

A single-crystal Si layer 403 was epitaxially grown by only 150 nm on the porous Si layer 402 by CVD (Chemical Vapor Deposition). The conditions were as follows.
Source gas: SiH₂Cl₂/H₂
Gas flow rate: 0.5/180 (ℓ /min)
Gas pressure: 80 (Torr)
Temperature: 950 (°C)
Growth rate: 0.3 (µm/min)

A 100-nm thick insulating film 404 was formed on the surface of the epitaxial single-crystal Si layer 403 by thermal oxidization (Fig. 4B).

The surface of the insulating film 404 on a first substrate 410 having the insulating film 404 and the surface of a separately prepared second substrate (single-crystal Si substrate) were bonded into a bonded substrate stack 440 (Fig. 4C).

A water jet was blown to the side surface of the bonded substrate stack 440 to divide the bonded substrate stack 440 into two substrates at the interface of the two-layered porous Si layer 402. A porous Si layer 402b formed by the first anodization was exposed on a second substrate 420 (Fig. 4D).

The second substrate 440 on which the porous Si layer 402b was exposed was set on a holding unit 102 of the etching apparatus 200 shown in Fig. 2. Only the porous Si layer 402b was uniformly, selectively etched (Fig. 4E).

The etching solution (etchant) used in the second example was 2 *ℓ* , which was about 1/2 the amount used in a conventional method of dipping a substrate in an etching solution.

After selective etching, an SOI substrate 450 having the 100-nm thick single-crystal Si layer 403 formed on the insulating film 404 was obtained. The film thickness of the single-crystal Si layer 403 was measured at 100 points within the entire plane to find that the film thickness uniformity was 101 ± 3 nm.

The SOI substrate 450 underwent annealing (hydrogen annealing) in a hydrogen atmosphere at 1,100°C for 1 h. Thereafter, the surface roughness was measured by an atomic force microscope to find that the mean square roughness of the SOI substrate 450 was about 0.2 nm in a 5 - µm□ region, which was equal to that of a commercially available Si substrate.

A porous Si layer 402a remaining on the first substrate 401 was also selectively etched by the etching apparatus 200 shown in Fig. 2. By performing hydrogen annealing or surface treatment such as mirror polishing, the first substrate 401 could be reused as the first or second substrate (Fig. 4E).

### [Third Example]

Four 8" substrates on each of which a porous Si layer was exposed were fabricated by anodizing a single-crystal Si substrate by the same method as that of the first example. In the two substrates, the porous Si layer was etched by a conventional etching method of dipping a substrate in an etching solution. In the remaining two substrates, the porous Si layer was etched using an etching apparatus 100 shown in Fig. 1.

As the etching solution (etchant), two etching solutions, one of which was forcibly contaminated by Cu at 500 ppb and the other of which was not contaminated, were adopted for each pair of the two substrates.

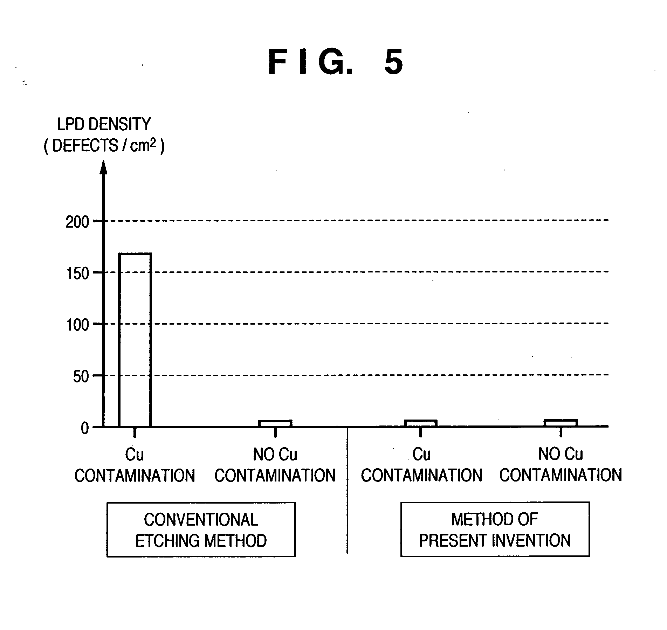

The four selectively etched single-crystal Si substrates underwent alkali cleaning, and then the LPD density at 0.14 µm or more was measured using a surface inspection device (laser counter). Fig. 5 shows the results.

The substrate in which the porous Si layer was etched by the conventional etching method of dipping a substrate in an etching solution exhibited an abnormal increase in LPD density upon dipping the substrate in the Cu-contaminated etching solution. To the contrary, the substrate in which the porous Si layer was etched using the etching apparatus 100 shown in Fig. 1 did not exhibit any abnormal increase in LPD density even in the use of the Cu-contaminated etching solution. In the use of the uncontaminated etching solution, the two substrates did not exhibit any abnormal increase in LPD density.

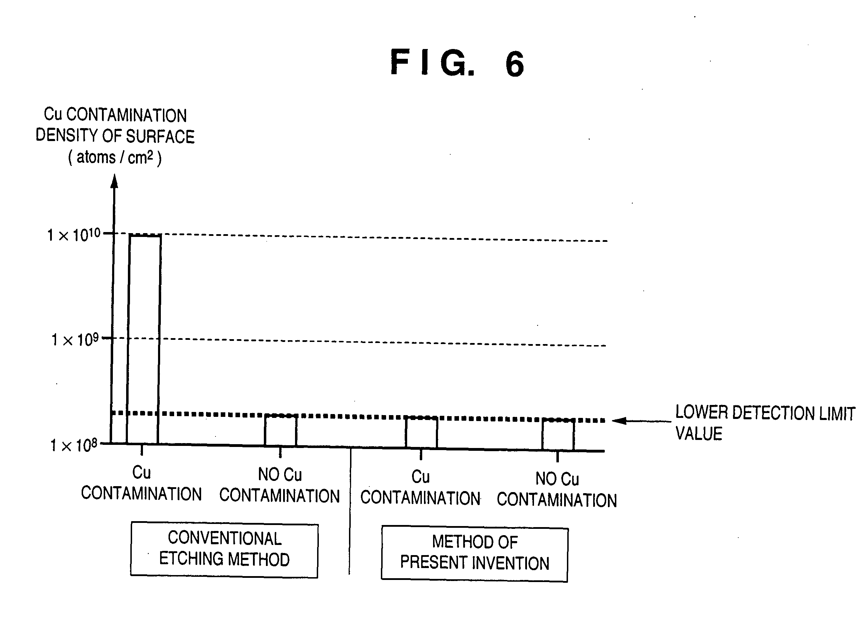

The metal on these substrate surfaces was analyzed after measurement by the surface inspection device (laser counter). Fig. 6 shows the results.

When the substrate in which the porous Si layer was etched by the conventional etching method of dipping a substrate in an etching solution was dipped in the Cu-contaminated chemical, a Cu concentration of 1 x 10¹⁰ atoms/cm² was detected. However, when the substrate in which the porous Si layer was etched using the etching apparatus 100 shown in Fig. 1 was dipped in the Cu-contaminated etching solution, the Cu concentration was a lower detection limit value or less. In the use of the uncontaminated chemical, the Cu concentrations of the two substrates were a lower detection limit value or less.

The present invention can suppress, e.g., the amount of etchant used.

As many apparently widely different embodiments of the present invention can be made without departing from the spirit and scope thereof, it is to be understood that the invention is not limited to the specific embodiments thereof except as defined in the claims.

An object of this invention is to suppress the amount of etchant used. A liquid etchant (3) is stored in an etchant vessel (4), and vaporized by a vaporization unit (6). A fragile layer (1a) such as a porous layer is selectively etched with the vaporized etchant.

## Claims

1. An etching method of etching a fragile layer of a member having the fragile layer, comprising:
vaporizing a liquid etchant to etch the fragile layer of the member with the vaporized etchant.

2. The method according to claim 1, wherein the fragile layer includes a porous layer or an ion-implanted layer.

3. The method according to claim 1, wherein
the fragile layer includes silicon having a fragile structure, and
the etchant contains hydrogen fluoride and hydrogen peroxide.

4. The method according to claim 1, wherein the liquid etchant is vaporized by heating.

5. The method according to claim 4, wherein the liquid etchant is vaporized by heating the liquid etchant to a temperature within a range of 40 to 50°C.

6. An etching apparatus for etching a member, comprising:
a reaction vessel which stores the member; and
a vaporization unit which vaporizes a liquid etchant by heating.

7. The apparatus according to claim 6, wherein the member stored in the reaction vessel is etched with the vaporized etchant.

8. The apparatus according to claim 6, wherein the vaporization unit is so configured as to vaporize the liquid etchant inside the reaction vessel.

9. The apparatus according to claim 6, wherein
the vaporization unit is so configured as to vaporize the liquid etchant outside the reaction vessel, and
the etching apparatus further comprises a supply portion which supplies the etchant vaporized by the vaporization unit into the reaction vessel.

10. The apparatus according to claim 9, wherein
the supply portion includes
an etchant vessel which stores the liquid etchant,
a first supply path which supplies a predetermined gas to the etchant vessel, and
a second supply path which communicates the etchant vessel with the reaction vessel, and
the supply portion is so configured as to supply the predetermined gas into the etchant vessel via the first supply path and supply the etchant vaporized in the etchant vessel into the reaction vessel via the second supply path.

11. The apparatus according to claim 6, wherein the vaporization unit is so configured as to be able to heat the liquid etchant to a temperature within a range of 40 to 50°C.

12. An etching apparatus for etching a member, comprising:
a reaction vessel which stores the member; and
a vaporization unit which vaporizes a liquid etchant inside the reaction vessel,
wherein the member stored in the reaction vessel is etched with the vaporized etchant.

13. The apparatus according to claim 12, wherein the vaporization unit is so configured as to vaporize the liquid etchant by heating.

14. An etching apparatus for etching a member, comprising:
a reaction vessel which stores the member;
an etchant vessel which is arranged outside the reaction vessel and stores a liquid etchant;
a vaporization unit which vaporizes the etchant in the etchant vessel;
a first supply path which supplies a predetermined gas into the etchant vessel; and
a second supply path which communicates the etchant vessel with the reaction vessel,
wherein the etchant vaporized in the etchant vessel is supplied into the reaction vessel via the second supply path by supplying the predetermined gas into the etchant vessel via the first supply path.

15. The apparatus according to claim 14, wherein the vaporization unit is so configured as to vaporize the liquid etchant by heating.

16. A substrate manufacturing method comprising steps of:
preparing a first substrate having a fragile layer and a transfer layer formed on the fragile layer;
bonding a surface of the transfer layer of the first substrate to a second substrate to fabricate a bonded substrate stack;
dividing the bonded substrate stack at a portion of the fragile layer; and
etching the fragile layer remaining on the transfer layer transferred to the second substrate,
wherein the etching step includes a step of vaporizing a liquid etchant and etching the remaining fragile layer with the vaporized etchant.

17. The method according to claim 16, wherein the fragile layer includes a porous layer or an ion-implanted layer.
